# EUROPEAN PATENT APPLICATION

(11) **EP 1 204 187 A2**
(43) Date of publication of application: **08.05.2002**
(21) Application number: 01123303.8
(22) Date of filing: 16.08.1993
(51) Int. Cl.: H02J 7/00

(54) **Battery charging system**

(30) Priority: 14.08.1992 DK 101692
(62) Divisional of application: 98109252.1
(71) Applicant: CHARTEC LABORATORIES A/S, 2920 Charlottenlund (DK)
(72) Inventor: Reipur, John, 2930 Klampenborg (DK); Ebbe, Juul-Hansen, deceased (DK)
(74) Representative: HOFFMANN - EITLE

(57) **Abstract**

A battery charging system is provided, comprising a rechargeable battery including at least one rechargeable battery cell, a pair of battery terminals and information means for containing information about the battery in the form of an information code, a charging apparatus for charging the rechargeable battery, the charging apparatus including a pair of charger terminals, means for releasably interconnecting the battery and the charging apparatus so that the battery terminals are in electrical conductive contact with the charger terminals, and information receiving means for electronically reading or sensing the information code of the information means of the battery, said charging apparatus further comprising control means for controlling the charging process based on the information code received by the information receiving means of the charger. The invention further relates to a battery for use in said rechargeable battery system.

## Description

When charging a rechargeable battery, such as for example an NiCd battery, an electrical voltage greater than the terminal voltage of the battery is applied to the terminals of the battery, whereby a current will flow through the battery. This current initiates a chemical process by which energy is stored in the battery.

When the battery has reached a full charge condition, the chemical process stops, and the added energy will instead be converted into heat. Since the battery is constructed as a sealed container, the pressure in the battery increases, which causes chemical destruction. This means that the capacity of the battery is reduced, and the capacity may eventually have been reduced significantly after several such chargings. For the battery to be utilized in the best possible manner it is therefore important to ensure not only that the battery will be charged fully, but also that charging is interrupted before the generation of heat becomes too great. Thus, it would be desirable to control the charging process so as to obtain an almost optimum charging and/or to interrupt charging at a proper time. Such accurate control of the charging process is especially important when it is desired to charge the battery as quickly as possible.

In a typical charging process the voltage across the battery increases evenly as the battery is charged. As the battery approaches its full state of charge, the voltage increases more steeply to a peak marking the full state of charge. The voltage then drops again owing to the increase in temperature because the temperature coefficient of the voltage is negative. Correspondingly, the charging current typically falls to a minimum at full charge and then increases.

A method has been devised of charging a rechargeable battery having a pair of terminals said method comprising connecting an electrical power source to the terminals of the battery, surveying the value and/or course of a least one characteristic parameter of the charging process during at least part of the process of charging the battery, comparing the value and/or course of said at least one charging parameter with corresponding values and/or courses of stored reference parameters representing idealistic or desirable charging processes for different types of battery and/or different battery conditions, selecting based on said comparison one of said stored sets of reference parameters, and controlling at least part of the process of charging the battery on the basis of one or more reference parameters of the selected set.

A first characteristic parameter may be controlled during at least part of the process of charging so as to obtain a predetermined desired course of a second of said characteristic parameters, and said first parameter may be the charging current while said second parameter may be the charging voltage.

When a battery is to be charged for the first time, or when the battery has been stored for a long time without charging, such battery (hereinafter called a "virgin battery") cannot immediately accept the normal full charging current. Therefore, the process of charging such virgin battery cannot be controlled in the same manner as another battery of the same type and with the same state of charge, but not being a virgin battery. Consequently, it would be advantageous to test the battery to be charged prior to actual charging in order to find out whether the battery is a virgin battery, which needs an individual "nursing" programme which may, for example, involve a relatively low charging current for a shorter or longer period of time. Also batteries not being virgins may show some kind of anomaly.

Therefore, a method has been devised of charging a rechargeable battery having a pair of terminals, said method comprising connecting the terminals of the battery to an electrical power source, initially test charging the battery by supplying a first test charging current to the terminals of the battery for a short first period of time, surveying or measuring at least one test parameter at least during part of the test charging process or at the end thereof, subsequently test discharging the battery for a short, second period of time, surveying or measuring at least one test discharging parameter during at least part of the test discharging pro-cess or at the end thereof, selecting or determining a course or values of at least one charging parameter based on said surveys or measurements of the test charging and/or discharging processes, and subsequently at least partly charging the battery substantially in accordance with the course or values selected for said at least one charging parameter.

The test charging of the battery may take place in any suitable manner. As an example, a predetermined fixed test charging voltage may be applied to the terminals of the battery for a predetermined period of time. Alternatively, the test charging voltage may be increased gradually or step-wise in a predetermined manner. In both cases the charging current, the temperature of the battery and/or the inner pressure of the battery may be surveyed or measured currently or at one or more selected points of the charging and/or discharging process.

Another possibility would be to control the test charging voltage so as to maintain the charging current at a predetermined level or so as to gradually or step-wise increase the test charging current in a predetermined manner. In the latter case the charging voltage, the temperature of the battery and/or the inner pressure of the battery may be surveyed or measured.

It may be advantageous to repeat the test charging and discharging processes one or more times. If so, the course of the controlled test parameter (charging voltage or charging current) may be chosen differently for successive test charging processes.

Preferably, a relatively low test charging current is supplied to the battery, for example in the order of 0.2 C/h (CmA x h being the capacity of the battery) so as to prevent the temperature and/or the inner pressure of the battery to attain values which could have a detrimental effect on the battery.

Each test charging period is preferably relatively short compared to the time period for the subsequent actual charging. As an example, each test charging may take a few seconds, such as 1 or 2 seconds.

The nursing programme selected on the basis of the testing described above may comprise the total charging process of the battery and even a subsequent discharging process and a new charging process. In case the nursing programme selected is terminated before the battery is fully charged the battery may be further charged, said further charging comprising surveying the value and/or course of a least one characteristic parameter of the charging process during at least part of the process of charging the battery, comparing the value and/or course of said at least one charging parameter with corresponding values and/or courses of stored reference parameters representing idealistic or desirable charging processes for different types of battery and/or different battery conditions, selecting based on said comparison one of said stored sets of reference parameters, and controlling at least part of the process of charging the battery on the basis of one or more reference parameters of the selected set.

A smaller or greater number of empirically determined reference parameters may be stored (such as drafts where values of the reference parameter is plotted versus the period of time lapsed since starting of the charging process), for example by electronic storing means, such as a memory. When it is desired to rapidly charge the rechargeable battery without substantially deteriorating the same the idealistic or desirable process- of charging mainly depends on the state of charge of the battery prior to starting the charging process. Therefore, the reference parameter courses stored represent idealistic or desirable processes of charging for different starting states of charge of the battery. If the state of charge of the battery to be recharged is known or may be determined, the reference course with the starting state of charge closest to the actual state of charge of the battery to be recharged may be selected, and the process of charging the battery may be controlled so as to approximate the course of said at least one parameter to the selected reference course, whereby it may be secured that the battery is not at any time exposed to unduly high voltage or charging current or to undue heating.

In principle, the state of charge of the battery to be recharged may be determined by a special measuring step, and the corresponding reference parameter course adapted to the same or a similar starting state of charge may then be selected, for example by providing the relevant information to an electronic control unit by suitable keys. The relevant reference course may be selected automatically by an electronic control circuit.

The charging parameter may, for example, comprise the potential across the battery terminals, the electric charging current supplied to the battery, the temperature of the battery cell, the rate of change of any such parameter, and any combination of such parameters and/or rate of change.

It should be understood that the charging process may be controlled in any suitable manner by which the course of the charging parameter may be approximated to the selected reference parameter course. The process of charging may be controlled by controlling the voltage supplied to the terminals of the battery. The voltage is preferably controlled so that the charging current supplied to the battery is relatively low at the beginning of the charging process, while the charging current is preferably maintained at substantially the same maximum value during a subsequent major part of the charging process, so as to accelerate the same.

As mentioned previously, the selection of reference parameters may depend on the state of charge of the battery. Such state of charge may be determined by briefly supplying a voltage to the battery prior to the initiation of the charging process so as to measure one or more charging parameters. In case the battery is fully charged the charging process will not be initiated. If the battery is partly charged, such information may be used in selecting proper reference parameters for the charging process.

The controlling of the charging process may comprise determining of a remaining period of charging time when the value of at least one characteristic parameter fulfils a certain predetermined condition or predetermined conditions, and the charging process is then terminated when such remaining period of time has expired. In an embodiment of the method according to the invention the remaining period of charging time is determined when the characteristic parameter, such as charging voltage, charging current, battery temperature, or inner battery pressure, has obtained a predetermined value.

Towards the end of the charging process the internal resistance of the battery cell may increase so that the charging voltage tends to increase when the charging current is to be maintained at a relatively high predetermined value. A too high voltage may course a detrimental temperature increase within the battery cells. Therefore, the voltage supplied to the terminals of the battery is preferably limited to a predetermined maximum, the charging process being terminated at the expiration of a predetermined remaining period of time starting when the voltage has reached said maximum. This means that the charging voltage is preferably kept at its maximum value during said predetermined remaining period of time, and as the inner resistance of the battery cells is increasing the charging current will normally decrease gradually during this period of time, which is preferably selected so that the battery is substantially fully charged when the said period of time has expired. Preferably, the predetermined remaining period of time is related to the reference course selected, which means that each reference parameter course includes information about not only the maximum charging voltage to be supplied to the battery, but also about the period of time in which such maximum voltage should be maintained at the end of the charging period.

As mentioned above, the reference parameter courses to be compared with the actual parameter course may be curves or graphs, and the comparison process may be performed by a design recognition technique by means of design recognition circuitry. The charging parameter may currently be measured at short time intervals during charging, the measured parameter values being compared with corresponding reference values of the reference parameter courses, and the relevant reference parameter course being selected on the basis of comparison of such measured values and reference values. The comparison process may be performed currently during the charging process so that the control circuit or control unit may shift from one reference parameter course to another when the continued comparison process reveals that the reference parameter course chosen first is not the one which is closest to the actual charging process.

In comparing the charging parameter values with the reference values it may be advantageous to compare the rate of change of the parameter values as a function of the charging time lapsed with similar reference values. As an example, the rate of change of the charging voltage as a function of the charging time lapsed may be compared with corresponding reference values. In order to permit the detection of the internal resistance or the potential of the battery the charging current may be cut off for a short period of time immediately prior to each measurement of the potential difference of the battery terminals.

The parameter values may be measured and the rate of change of the parameter values may be determined at uniform first time intervals, each determination of the rate of change being based on parameter values measured at second time intervals, the second time interval being a multiple of the first time interval. The parameter values may be measured rather frequently, which means that the said first time interval may be relatively short, for example about 10 seconds. The rate of change is, however, preferably based on measurements with a time spacing being several times greater, for example 90 seconds.

The determination of the rate of change may be initiated at the beginning of the the charging process. However, the determination of the rate of change may advantageously be postponed until a measured value of the characteristic parameters exceed a predetermined value, when it is obvious that the best distinguishable rates of change are found after such predetermined value of the parameter.

In a particular embodiment there is just a limited number of reference values, and a new stop point of time for the charging process is determined only when the parameter or parameters concerned assume one of the reference values. This results in a simpler procedure which can nevertheless normally determine the optimum stop point of time sufficiently accurately.

As mentioned above, when the parameter being measured is the voltage across the connection terminals of the battery, a more exact measurement is obtained if the charging current to the battery is cut-off for a short period before the voltage is measured. The reason is that the battery has an internal series resistance, and the charging current provides a voltage drop across this resistance which should not be included in the voltage measurement.

In particular in case of fast charge mode using a high charging current it may be advantageous to reduce the charging current gradually as the stop point of time approaches, because it will then be easier to find the optimum stop point of time. Thus, charging may, for example, be performed with-a constant high charging current (for example about 4C milliamperes, when the capacity of the battery is C milliamperes x hour) until one of the measured parameters has reached a determined level, following which the current can be reduced gradually.

An expedient manner of obtaining the desired charging current is to use a constant voltage source which is pulse width modulated in a manner providing the desired charging current.

It may be an advantage that the procedure of determining the possible stop point of time for the charging process is not initiated until the charging process approaches its termination. Thus, a simpler method may be used, such as simple measurement of current or voltage, for deciding when the more accurate procedure is to be initiated.

In a particular embodiment the accuracy of the measurements is improved in that each of the measured values of the characteristic parameters for each of the mentioned points of time is an average value of a plurality of intermediate measurements. The measurements will then be less sensitive to transients, for example. Of course, the same effect can be obtained by integrating the parameter in question over the period which has elapsed since the last measurement.

As an additional safeguard some of the stop criteria used in prior art methods may be adopted. Thus, for example, a maximum charge period may be fixed. Charging will then be interrupted at this point of time at the latest even though the other stop criteria have not yet occurred. It is also possible to fix limits for one or more of the measured parameters so that charging is terminated if one of the parameters exceeds or drops below specific values. Furthermore, the charging process may be interrupted if and when said at least one value or course surveyed deviates too much from any of the corresponding courses or values of the stored reference parameters.

After the termination of charging it may be expedient to maintain the charge state of the battery by means of a pulsating current. This ensures that the battery is constantly fully charged even if it is not removed from the charger till long after the termination of the charging.

The reference parameter courses stored may comprise not only courses representing charging processes which are idealistic or desirable for one and the same type of battery, but even a plurality of reference parameter courses for each of two or more different types of battery. In such case the first process step may be to determine the type of the battery to be charged and to select the reference parameter courses related to that type of battery. Thereafter, the process may proceed as described above.

An apparatus has been devised comprising connecting means for connecting the battery to an electrical power source, means for surveying the value and/or course of at least one characteristic parameter of the charging process during at least part of the process of charging the battery, storing means for storing a plurality of the values and/or courses of reference parameters representing idealistic or desirable charging processes for different types of battery and/or different battery conditions, means for comparing the value and/or course of said at least one charging parameter with the values and/or courses of the stored reference parameters and for selecting based on said comparison one of said stored sets of reference parameters, and means for controlling at least part of the process of charging the battery on the basis of one of more reference parameters of the selected set.

The operation of such an apparatus may, for example, be controlled by a microprocessor or another electronic control device, which may also comprise a memory for storing the reference parameter courses or values.

The present invention provides a battery system comprising a rechargeable battery including a pair of battery terminals and information means for containing information about the battery, and a charging apparatus including a pair of charger terminals, means for releasably interconnecting the battery and the charging apparatus so that the battery terminals are in electrical conductive contact with the charger terminals, and information receiving means for receiving information from the information means of the battery, whereby the charging of the battery may be controlled based on said information. The battery system may comprise control means for controlling the charging process based on information received by the information receiving means.

The information means of the battery may be more or less sophisticated. In the most simple form the information means may, for example, comprise an indicator which is removed, inactivated and/or destroyed when the battery is charged for the first time. The presence of such an indicator would inform the control means that the battery should be charged in accordance with a "nursing programme" suitable for a virgin battery of the battery type in question. Alternatively or additionally, the information means may comprise an information code which may be read or sensed by the information receiving means of the charger. Such information code may be read or sensed by mechanical, optical, electromagnetic and/or electronic reading or sensing means, and the code may, for example, contain information about the type, capacity, maximum charging voltage, maximum charging current, maximum temperature, maximum inner pressure and/or other characteristics of the battery. Furthermore, the information means may, alternatively or additionally, comprise a temperature sensor for sensing the temperature of the battery.

In a preferred embodiment of the battery system the charging current and/or charging voltage may initially be increased when the temperature sensed by the temperature sensor is low.

The invention also relates to a rechargeable battery for use in a battery system as described above, said battery comprising a pair of battery terminals and information means for containing battery information in a form which may be sensed or read by suitable information receiving means of a corresponding battery charging apparatus.

As described above, the information means may be rather simple. Alternatively, the information means may comprise an electronic memory for storing battery information. This battery information may then comprise information about one or more previous charging and discharging processes and/or about the present state and condition of the battery and its individual cells. Thus, the information means of the battery may inform the control means in detail about the condition of the battery, and the control means may then control the charging process on the basis of such information. Such charging may be controlled in accordance with any of the methods described above or by means of conventional charging methods. The battery information may for example comprise information about the type of the battery, the capacity of the battery, other specifications of the battery, charging status of the battery, the condition of the various battery cells, the last charging process, the last discharging pro-cess, the time period lapsed since the last charging and/or discharging process, charging parameter algorithms, and/or the internal battery pressure.

In order to survey the internal pressure and/or temperature of the battery the information means may comprise a pressure and/or temperature sensor located within the battery. These sensors are connected or connectable to the control means so that information about pressure and/or temperature may be transmitted to the control means.

The control means are preferably adapted to control charging of individual cells of the battery in response to information received from the information means, whereby it may be ensured that the cells of the battery are substantially uniformly charged.

It should be understood that the battery could also comprise an electronic display for displaying information from the memory in a directly readable form. It is also envisaged that the battery could also contain the control means. This means that the charging apparatus is eliminated or included in the battery unit. In such case the battery should just be connected to a suitable electrical power supply.

Usually, the battery comprises several battery cells and in order for the information means to obtain information about the individual cells, such as voltage and/or temperature of each cell, the battery may further comprise means for measuring the voltage of each battery cell and means for storing the measured cell values in the information means.

In connection with the method of charging described above it is presupposed that courses or sets of reference parameters for the type of battery in question are known and available. A method has been devised for providing such courses or sets of reference parameters. Thus, a method has been devised of determining a process of charging a rechargeable battery having a capacity C, said method comprising determining a maximum value for at least one charging parameter and controlling the charging process so as to not exceed the maximum value or values determined.

It is normally desirable to fully charge a battery within the shortest possible charging period of time. However, the chemical reactions taking place within the cells of the battery limit the rate of charging. When the charging current is relatively low the charging current may be increased by increasing the charging voltage without any increase of the battery temperature, and the temperature of the battery may even drop slightly when the charging current is increased. However, when the charging current has reached its maximum value determined by the chemical reactions a further increase of the charging voltage may cause a drastic increase of the battery temperature and also of the internal pressure of the battery which is detrimental to the battery. A maximum value for the battery and/or cells thereof may be determined for the temperature, the difference in temperature, the inner pressure, the charging voltage, and/or the terminal voltage. The charging process should then be controlled so that the maximum value or the maximum values is/are not exceeded during the charging process.

As an example, the maximum value and/or difference of the battery/cell temperature and/or the inner battery/cell pressure may be determined as the temperature and/or difference in temperature and/or pressure obtained when a relatively low charging current is supplied to the battery for a certain period of time, for example in the order of one hour or even up to 10 or 15 hours. The charging voltage may then be controlled so that the charging current is kept substantially constant at least during the later part of the charging process. The charging current supplied to the battery may, for example, be 0.05-0.3 C/h, 0.1-0.3 C/h, preferably 0.2-0.25 C/h (C/h being the so-called C-rate). This means that when the capacity of the battery being charged is for example C mA•h, the charging current may be 0.05-0.3 C mA, 0.1 C mA and preferably 0.2-0.25 C mA. Such charging current is relatively low and requires a charging time of 3.3-10 hours to fully charge the battery.

In order to obtain a shorter charging time it is necessary to use a higher charging current in the major part of the charging period. The maximum value of the charging and/or terminal voltage is determined as the maximum voltage obtained when a relatively high charging current is supplied to the battery for a certain period of time. Such relatively high charging current may, for example, be 0.75-1.5 C/h, preferably about 1 C/h. When such a charging current is used the necessary charging time for fully charging the battery-is 0.67-1.34 hours.

The charging current may be supplied to the battery in a period of time sufficient to partly charge the battery. It is preferred, however, to continue supplying charging current to the battery till the battery is substantially fully charged.

When determining one or more of the above mentioned maximum parameters it is preferred that the battery is at least partly charged at a slow rate and subsequently discharged at least once prior to any further charging. It is further preferred that the relatively low charging current is supplied to the battery for such a long period of time that a rise in at least one of said charging parameters, such as battery or cell temperature, has been obtained and no further essential parameter change has been detected.

The real value of the capacity of the battery will often vary from the capacity stated by the battery manufacturer. Thus, it is an object of the present invention to provide a method for determining the real value of the capacity of the battery. This method comprises charging the battery at said relatively slow rate and determining the capacity value of the battery by calculating or measuring a total first charging power supplied to the battery during charging until the battery is substantially fully charged. The point of time when the battery is substantially fully charged may be determined as the point of time when no further rise in parameter value(s) has (have) been detected for a predetermined period of time. Said parameter values may for example be the temperature and/or the terminal voltage of the battery and/or cells thereof.

When determining the maximum value of the charging or terminal voltage it is preferred to charge the battery with a charging current which is substantially equal to the C-rate based on the determined real value of the capacity of the battery. Furthermore, it is preferred to determine the maximum value of the voltage as the voltage measured across the battery or cell terminals at the point of time when the battery or cell temperature has increased by said maximum temperature difference determined during charging with said relatively low charging current. It is also preferred that the battery is substantially discharged before initiating any charging process for determining charging parameters.

If the battery is a virgin battery, which means that the battery is being charged for the first time or a rather long period of time has passed since last charging, it is important to ensure that the battery "gets started" which means that the chemical reaction within the cells is normal. This may be obtained by a nursing program as previously explained. Thus, the battery may be at least partly charged rather slowly and subsequently discharged at least once prior to determining the maximum value of said at least one maximum parameter.

A set of maximum values obtained in the manner described above may form a reference for use in a method of charging as previously described. Further reference values or parameters may be obtained by controlling other charging parameters so as to not exceed the maximum charging parameters determined.

A set of maximum values and/or parameters which may be obtained as described above may be used in a controlled method of charging. The battery is then charged with a substantially constant charging current during part of the charging process, said substantially constant charging current preferably being several times the C-rate based on the capacity value determined or measured. As an example, the value or parameter may be the voltage. In that case the voltage(s) of the battery or cell terminal(s) is (are) surveyed, and when a predetermined maximum terminal voltage of the battery or cell has been reached at a time Tmax, the charging process is controlled so as to maintain the battery or cell voltage substantially constant for the remaining period of the charging process. If the battery has at least two cells, the parameter or voltage of each cell of the battery may be surveyed, and the remaining period of the charging process may be controlled based on the voltage of the cell having a voltage first reaching the maximum cell terminal voltage. It should be understood that the charging process could be controlled based on any other charging parameter, such as the temperature of the battery or of the individual cells thereof.

It is also preferred that the stop point of time of the remaining charging period of the charging process is determined by surveying the charging current, and when no further decrease in the charging current has been detected for a predetermined period of time the charging process may be terminated. Alternatively, the charging process is stopped at a time Tstop, the remaining charging period Tstop minus Tmax being determined generally at the time Tmax when the predetermined maximum battery or cell terminal voltage is reached. The remaining charging period of time Tstop minus Tmax may be determined on the basis of a comparison of the battery or cell terminal voltage course with stored reference voltage courses, or the remaining charging period of time may be determined in dependency of the value of Tmax.

The stop point of time Tstop and thus the remaining charging period of time may be determined based on a comparison of the time Tmax at which the maximum voltage is reached with stored reference values of time and corresponding remaining charging periods of time.

In connection with discharging when the battery is used in operation, a method has been devised for controlling a discharging process of a rechargeable battery having at least two cells, said method comprising surveying the voltage of each cell of the battery, and interrupting the discharging process when the voltage of-at least one cell drops to a predetermined threshold voltage.

The invention will now be further described with reference to the drawing, in which
Fig. 1 is a graphical representation or curve showing the voltage as a function of time for an NiCd battery which is charged with a constant charging current,
Fig. 2 shows in an enlarged scale part of the curve of Fig. 1,
Fig. 3 is a graphical representation of the course of various charging parameters in a controlled process of charging a NiCd battery,
Fig. 4 is a graphical representation showing the battery voltage of a NiCd battery as a function of charging time for six different starting states of charge,
Fig. 5 is a block diagram of an apparatus for battery charging,
Fig. 6 shows a circuit diagram of an embodiment of the apparatus shown in Fig. 5, and
Fig. 7 is a graphical representation corresponding to that shown in Fig. 3 for a battery with some anomaly,
Figs. 8 and 9 diagrammatically illustrate charging curves at the beginning of a process of charging a virgin battery and a fully charged battery, respectively,
Figs. 10 and 11 diagrammatically illustrate discharging curves for a virgin battery and a fully charged battery, respectively,
Fig. 12 shows the charging voltage curve and the temperature curves for a battery which is charged with a constant low charging current,
Figs. 13, 14 and 15 show the charging voltage curves and the temperature curves for the same battery as in Fig. 12 when charged with substantially constant charging currents of different values, respectively,
Fig. 16 shows the charging voltage curve and the temperature curve for a battery which is test charged with a constant low charging current in the range of 0.1 C/h,
Fig. 17 shows the charging voltage curve and the temperature curve for a battery which is test charged with a constant charging current in the range of 1 C/h,
Figs. 18, 19 and 20 show the charging voltage curves, the temperature curves and the charging voltage curves for a NiCd battery which is charged with charging currents of different values,
Fig. 21 shows the charging voltage curve, the temperature curve and the charging current curve for a Nickel Metal Hydride battery which is initially charged with a high charging current,
Fig. 22 is a block diagram of a battery,
Fig. 23 shows the discharging voltage curves for each cell in a NiCd battery having 6 cells and being discharged with a constant current,
Fig. 24 illustrates a controlled discharging process for a NiCd battery having 6 cells,
Fig. 25 shows the charging voltage curves and the temperature curves of each cell of a NiCd battery having 6 cells and being charged with a constant charging current, and
Figs. 26, 27 and 28 are block diagrams showing different embodiments of a battery systems according to the invention.

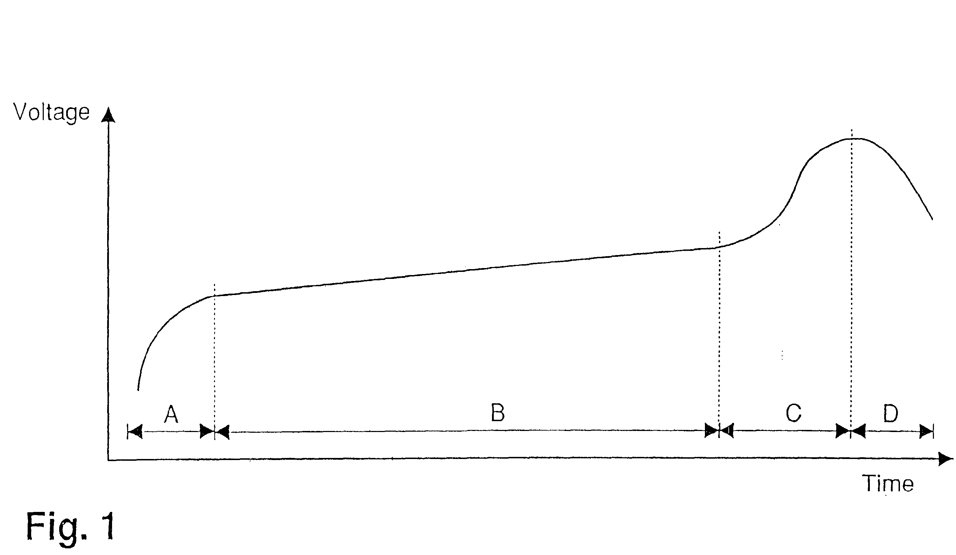

Fig. 1 shows a typical charging sequence for an NiCd battery. The curve shows the battery voltage as a function of time with a constant charging current. The overall curve shape will be the same for all NiCd batteries but the specific voltage and time values may vary, for example with the actual charging current and from battery to battery. The curve may be divided into regions representing various stages in the charging process. Fig. 1 indicates four regions which are marked A, B, C, and D, respectively.

The region marked A constitutes the start of the charging process. When the charging process is initiated, the voltage may vary somewhat depending upon the state of charge of the battery prior to the initiation of charging. Thus the voltage in this region is rather indefinite, and therefore no measurements proper are usually performed in this region.

The letter B indicates the actual charging period where the charging current is converted into stored energy in the battery by a chemical process. In this period the voltage of the battery increases only slowly. In the region C the full state of charge is approaching, and the voltage begins to increase more rapidly. At the end of the period C oxygen begins to develop in the cells of the battery which results in an increase in pressure and in temperature in the battery. This means that the voltage now increases more slowly because of its negative temperature coefficient. The battery voltage does not increase additionally at the transition between the regions C and D, and the voltage has thus reached its highest value or peak value.

If the charging process is continued in the region D, the battery voltage will drop because the electrical energy is now generally converted into heat. The resulting increase in temperature and pressure will cause destruction of the battery whose capacity is thus reduced. Therefore, the charging process should advantageously be cut-off at the commencement of or in the beginning of the period D.

The invention is based on the fact that it has been found by tests that even though the curve may vary somewhat in response to the charging current used and the "charging history" of the battery in question there is close correlation between various charging parameter values within the regions A, B and C, such as the slope of the voltage curve at a certain time or moment in the region C and the time difference from the moment in question to the optimum stop point of time for the charging process.

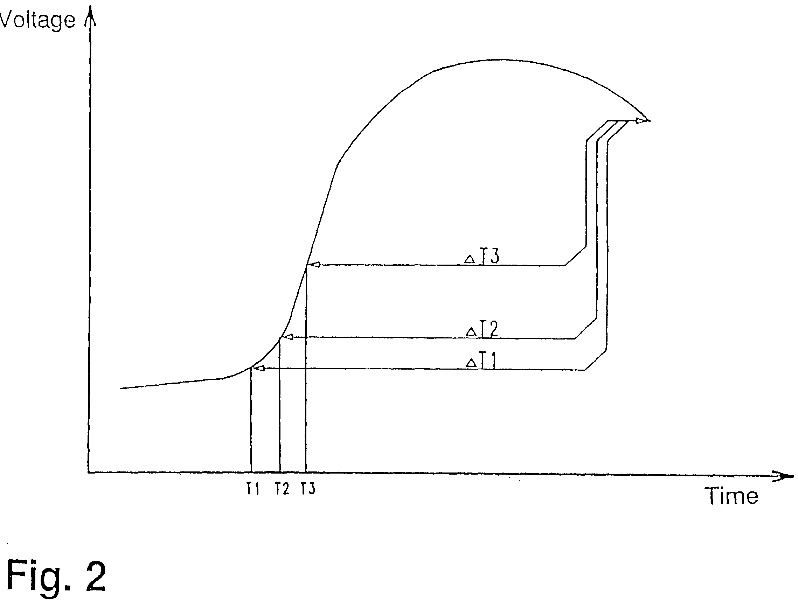

If the information about the correlation is stored in an electronic circuit it is relatively simple to calculate or determine how long charging of the battery should be continued and thereby the optimum stop point of time for the charging process, after having measured the slope of the curve at a given moment. If this calculation is performed at several consecutive moments, a corresponding number of proposals for the optimum stop point of time will be obtained. Fig. 2 shows an example where three measurements are performed. A remaining charging period of delta T1 is calculated at the point of time T1, a remaining charging period delta T2 is calculated at the point of time T2 and a remaining charging period delta T3 is calculated at the point of time T3. In the figure, the three calculated stop points of time occur at precisely the same moment. However, in practice the calculated stop points of time will usually be slightly different with a consequent number of proposals for stop points of time. In the embodiment of the invention described here, it is decided to cut-off the charging process when the first one of the calculated stop points of time occurs. Since a microprocessor is incorporated in the apparatus described below, more sophisticated stop criteria are also conceivable. Thus, it will be possible, for example, to attach more importance to the stop points of time last calculated. It is possible, for example, to disregard some of the values calculated first if all the subsequent calculations gather around a specific value.

As mentioned, Figs. 1 and 2 show the voltage across the battery as a function of time when a constant charging current is used. A corresponding typical curve will result if the charging current is plotted as a function of time with a constant charging voltage, and reproducible curves showing the above-mentioned stages in the charging process will be obtained even if neither charging current nor charging voltage is kept constant. It will be appreciated that these curves can be used in a manner similar to what is described above.

Corresponding curves of a different appearance will be obtained for other battery types. For some of them the correlation between the actual measurement point of time and the optimum remaining charging time will not necessarily be associated with the slope of the curve at the moment in question, but with other parameters for the curve, for example, the absolute voltage at the moment concerned.

Measurement of the slope of the voltage curve currently, may for example be performed every tenth second. For each measurement a remaining charging period and thereby a new proposal for a stop point of time is calculated. The processor can then either store this value together with the others, or it can incorporate it in a more sophisticated calculation of when the charging pro-cess is to be terminated.

A limited number of reference values for the slope of the curve may be prestored. In each measurement the actual slope of the curve is compared with the reference values, and only when the slope passes one of the reference values the processor will calculate a new stop point of time. In this manner, calculating time for the processor is saved in this manner, and the result will be fully satisfactory in many situations.

As mentioned, the curves in Figs. 1 and 2 are provided with a constant charging current. However, an alternative possibility is to cut-off the charging current briefly each time a voltage measurement is performed. A quite corresponding curve is obtained in this manner, but the absolute voltage values will be slightly lower because the curve does not include the voltage drop involved by the charging current across the internal resistance of the battery. Since this internal resistance typically increases at the end of the charging sequence, a voltage measurement without this contribution will be a more accurate measure of the state of the battery.

As mentioned before, reproducible curves will be obtained even if the charging current is not kept constant during the entire charging procedure. The principle of the invention can therefore very well be combined with a charging procedure where charging is initially performed with a constant, high current which is then reduced toward the end of the charging procedure. By using the lower charging current during the last portion of the charging process it will be possible to determine the optimum stop point of time more precisely, without the overall charging time being diminished noticeably. This may be combined with the performance of just a simple voltage measurement during the first portion of the charging process. When the voltage has reached a predetermined value, the charging current may be reduced, and the measurement of the slope of the curve may be initiated as described above. Of course, it is also possible to reduce the charging current at one voltage value and initiating the measurement of the slope of the curve at another voltage value.

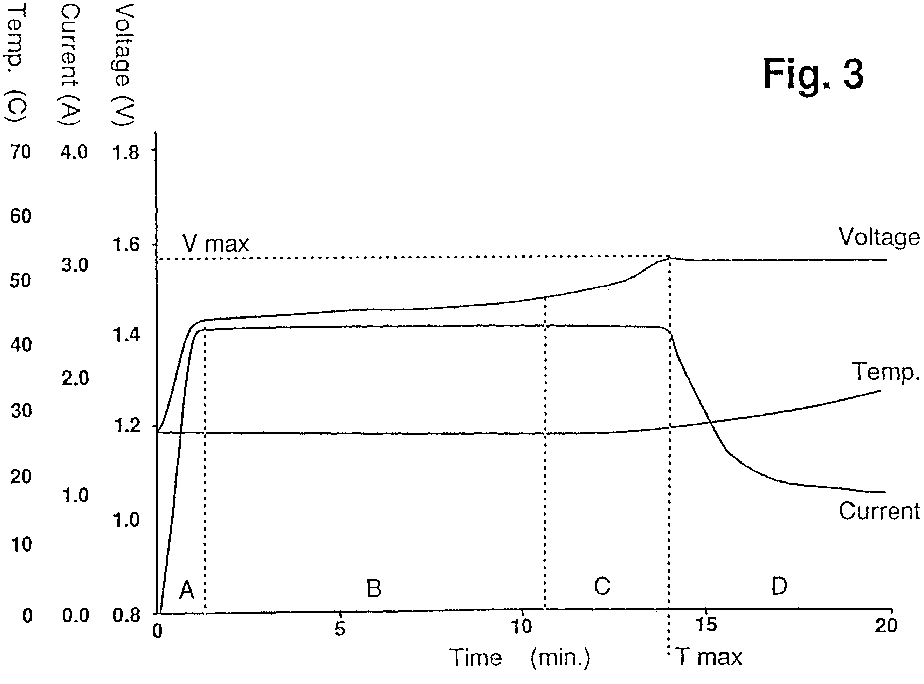

Fig. 3 shows typical charging curves obtained in accordance with an embodiment of the method according to the invention when charging a NiCd battery. The voltage curve shows the battery voltage as a function of time, when the voltage supplied to the battery is controlled in accordance with the invention in order to obtain an optimum charging current curve and an optimum battery temperature curve. The battery voltage curve may be divided into regions representing various stages of the charging process similar to Fig. 1. Fig. 3 shows four regions which are marked A, B, C and D, respectively.

The region marked A constitutes the start of the charging process. Here, the voltage supplied is controlled so that the charging current supplied to the battery is relatively low.

The B region indicates the actual charging period where the charging current is converted to stored energy in the battery. Here, the voltage supplied is controlled so that the charging current i maintained at substantially the same maximum value, which is determined in dependency of the type of battery involved, and the voltage across the battery increases only slowly.

In the C region the battery approaches its state of full charge and in order to maintain the maximum charging current the voltage across the battery begins to increase more rapidly until the voltage across the battery terminals reaches the predetermined maximum Vmax, which may be different for different types of batteries and which may, for example, be determined as previously described.

In the D region the voltage supplied is controlled so that the measured voltage across the battery terminals is maintained substantially at the maximum limit, Vmax. In the regions C and D the internal resistance of the battery cell is increased, and for a constant battery voltage, as in the D region, the resulting charging current will decrease. Due to the fact that the battery voltage is kept at a constant value in the region D the resulting temperature increase is relatively low keeping any destructive effect caused by the charging current to the battery cells at a minimum.

Not later than the time Tmax when Vmax is reached the remaining charging period is determined. When such remaining charging period starting at Tmax has lapsed the charging process is being terminated. The charging current fed to the battery is controlled by pulse width modulating a constant voltage source.

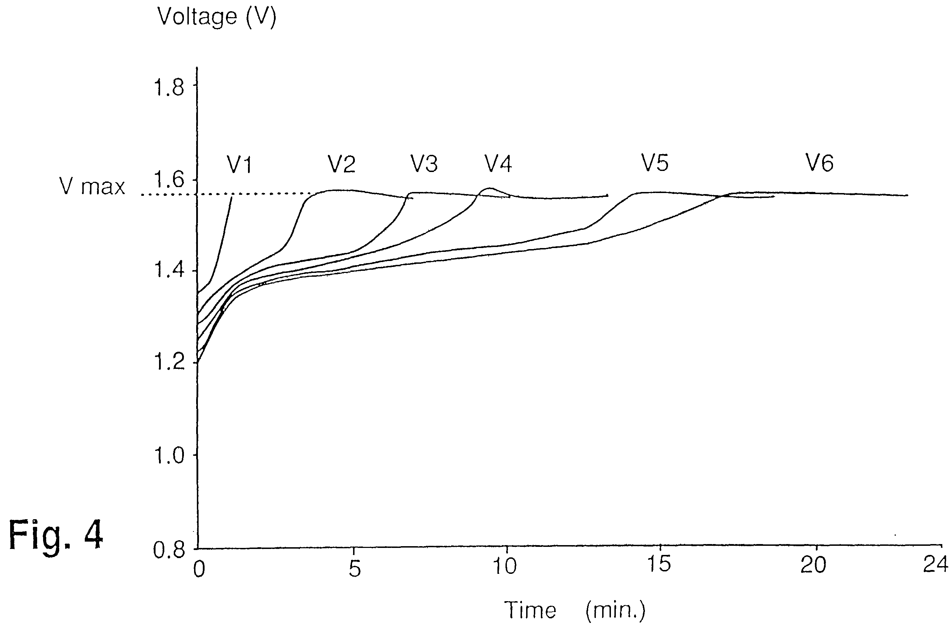

The voltage curve shown in Fig. 3 represents a process of charging a NiCd battery which is nearly unloaded. Fig. 4 shows six similar voltage curves V1 - V6 representing different charging courses for the same battery with different starting charges. The curve V1 represents the charging pro-cess of the battery when nearly fully charged and the curve V6 represents a charging process of the battery when almost fully discharged. Fig. 4 shows the charging period necessary for obtaining the maximum voltage Vmax increases when the starting state of charge of the battery decreases. It can also be seen from Fig. 4 that the "remaining charging time", which is the time period from the reach of Vmax till the charging process is terminated, increases when the starting state of charge of the battery decreases.

Information about ideal or desired reference voltage curves for the type of battery in question for a plurality of different starting charge conditions of the battery may be stored in an electronic memory. By comparing the course of the actual voltage curve, such as the slope of the curve with the stored reference values, the relevant reference voltage curve and the "remaining charging time" associated therewith may be determined.

The slope of the voltage curve may be measured currently, for example every tenth second during the charging process. For each measurement a comparison is made with the stored reference slopes and a new proposal for a "remaining charging time" is determined. When the measured battery voltage reaches the stored maximum voltage Vmax determination of the "remaining charging time" is cancelled and the last determined "remaining charging time" value is used.

Another embodiment which also results in charging curves of the type shown in Figs. 3 and 4 comprises prestoring a limited number of reference values for the slope of the voltage curve. In each measurement the actual slope of the curve is compared with the reference values, and only when the slope passes one of the reference values a new "remaining charging time" value is determined.

Curves corresponding to those shown in Figs. 3 and 4 will also be obtained for other battery types. These curves might be of different appearance and for some of them the correlation between the time for reaching the voltage Vmax and the optimum remaining charging time will not necessarily be associated with the slope of the voltage curve in question, but with other parameters of the curve, such as the absolute voltage at the moment concerned. The more parameters measured and stored, the more sophisticated determinations can be made in order to determine the optimum remaining charging time.

A further embodiment of the method resulting in charging curves of the type shown in Figs. 3 and 4 comprises measuring the battery voltage at a fixed time together with measuring the slope of the voltage curve when the maximum voltage Vmax is reached. In this embodiment the voltage together with the slope of the voltage curve can be incorporated in a more sophisticated determination of the optimum remaining charging time.

The voltage curves shown in Figs. 3 and 4 have been plotted by measuring the voltage across the battery terminals when the battery is being charged. However, an alternative possibility is to cut-off the charging current briefly each time a voltage measurement is performed. A quite similar curve is obtained in this manner, but the absolute voltage values will be slightly lower because the curve does not include the voltage drop involved by the charging current across the internal resistance of the battery. Since this internal resistance typically increases at the end of the charging sequence a voltage measurement without this contribution will be a more accurate measure of the state of the battery.

In the embodiments described above the measurement of the slope of the curve takes place in the following manner. At each measurement point of time, i.e. for example every tenth second, the voltage of the battery is measured, and then an electronic processor may store this voltage value in a storage circuit. The processor then calculates the difference between this value just measured and, for example, the value which has been measured 90 seconds ago and this difference is used as a measure of the slope of the curve at the time in question. In this manner a new value of the slope which has been measured over a period of for example 90 seconds is obtained every ten seconds.

To prevent the voltage measurements from being affected by transients and the like the voltage is preferably measured much more frequently, for example 100 times, between each of the said measurement points of time. Each of these intermediate measurements is stored by the processor, and at the actual measurement points of time the processor calculates an average of the 100 intermediate measurements which have been performed since the last measurement point of time.

When the charging process has been terminated as described above, maintenance charging of the battery may take place if the battery is left in the charger. This takes place by passing current pulses through the battery at intervals. These current pulses and the time between them are adapted such that they compensate for the self discharge of the battery which would otherwise take place. The pulses may, for example, have a duration of 15-30 seconds and the time intervals between the subsequent pulses may be a few hours.

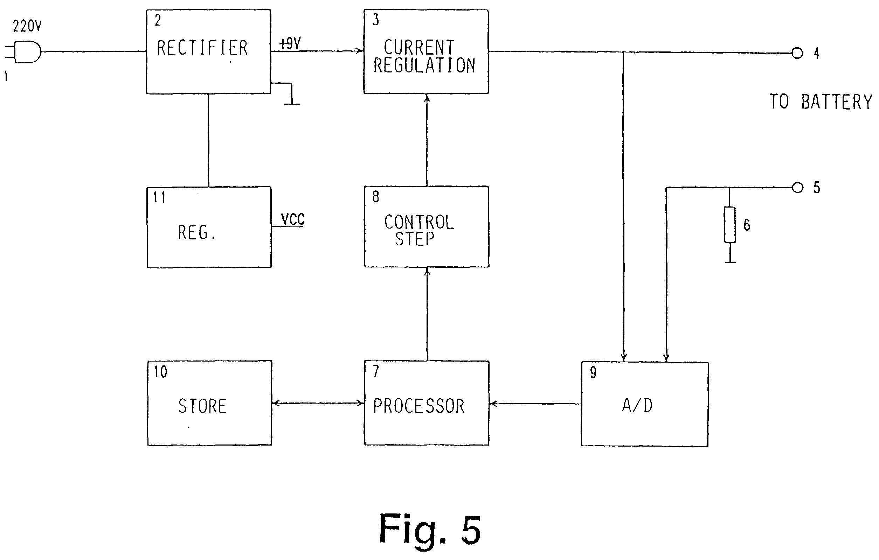

Fig. 5 shows a block diagram of an embodiment of an apparatus for battery charging. 220 volts are applied to the apparatus by means of an ordinary plug 1, and the voltage is converted in the rectifier block 2 to a 9 volts direct voltage. 3 shows a current regulator which supplies current to the battery to be charged via the terminals 4, 5. The current from the battery flows via the terminal 5 and the resistor 6 via ground back to the rectifier circuit 2. The current regulator 3 is controlled via a control stage 8 from a processor 7. The processor 7 is capable of measuring current and voltage by means of an analog/digital converter 9. The charging current is measured by measuring the voltage drop across the resistor 6 while the voltage of the battery is obtained as the difference between the voltages measured on terminals 4 and 5, respectively. The processor 7 is moreover connected to a storage circuit 10, which is used i.a. for storing measured current and voltage values as well as the calculated stop points of time. A regulator circuit 11 generates a direct voltage of 5 volts from the voltage of 9 volts from the rectifier circuit 2. The voltage of 5 volts is used for supplying the circuits 7, 9 and 10. The current regulator 3 is controlled by means of pulse width modulation and the processor 7 controls the pulse width in a manner such that the desired charging current constantly flows through the battery. The processor measures the charging current, as mentioned, by measuring the voltage drop across the resistor 6. If desired, the processor may perform the voltage measurement across the battery in the intervals between the current pulses. The voltage measurement will then not be affected by the voltage drop caused by the charging current across the internal resistance of the battery.

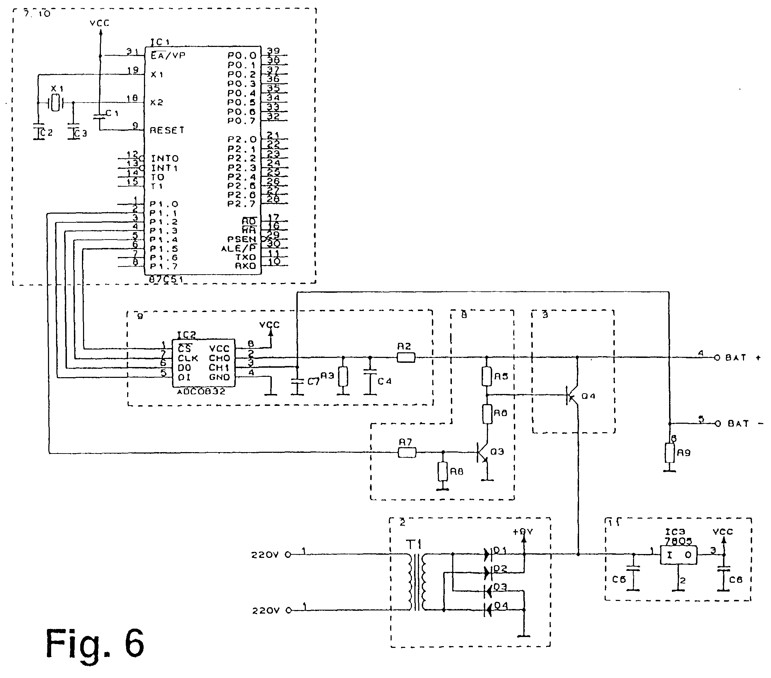

Fig. 6 shows a circuit diagram of an embodiment of the apparatus shown in Fig. 5. The blocks of Fig. 5 are shown in broken lines and are provided with the same reference numerals as in Fig. 5. The rectifier block 2 comprises a transformer T1 as well as a rectifier coupling consisting of the four diodes D1, D2, D3, and D4. The output voltage from this block is a direct voltage of 9 volts, which is passed partly to the current regulator 3 and partly to the regulator circuit 11. The current regulator 3 comprises a transistor Q4 and is controlled via the control stage 8 of the processor ICl. The control stage 8 comprises the resistors R5, R6, R7 and R8 as well as a transistor Q3. When the output terminal P1.1 of the processor has a high output signal the transistor Q3 will be in conductive state via the voltage divider comprising resistors R7 and R8. Current will hereby flow through the voltage dividers R5 and R6 causing Q4 to assume a conductive state whereby current is supplied to the battery. When the output terminal P1.1 of the processor is low the transistor Q3 as well as the transistor Q4 will be in a non-conductive state and no charging current is fed to the battery.

The analog/digital converter 9 comprises the integrated circuit IC2 as well as the resistors R2 and R3 and the smoothing capacitors C4, C7. The measured voltages which are indicative of the battery voltage and the charging current, respectively, are converted to digital information in the integrated circuit IC2, and this digital information is passed further on to the terminals P1.2 and P1.3 of the processor.

In this embodiment the processor circuit ICl comprises the processor 7 as well as the storage circuit 10. Further, the capacitors Cl, C2 and C3 as well as a crystal Xl are connected to the processor. Otherwise, the mode of operation of this processor circuit is generally conventional.

The regulator circuit 11 comprises the integrated voltage regulator IC3 as well as the capacitors C5 and C6. This circuit supplies a direct voltage of 5 volts to the circuits ICl and IC2.

The circuit described may be used no matter whether it is decided to control the voltage so as to maintain the charging current at a substantially constant value, or to control the current during charging of the battery so as to maintain a substantially constant voltage, or combinations of such methods.

When charging a rechargeable battery in accordance with the present invention as described herein the charging process may be controlled so that the voltage measured across the battery terminals during "the remaining charging period" is kept at a constant value when a predetermined maximum voltage value Vmax has been reached. Vmax for a certain type battery may be determined as described above.

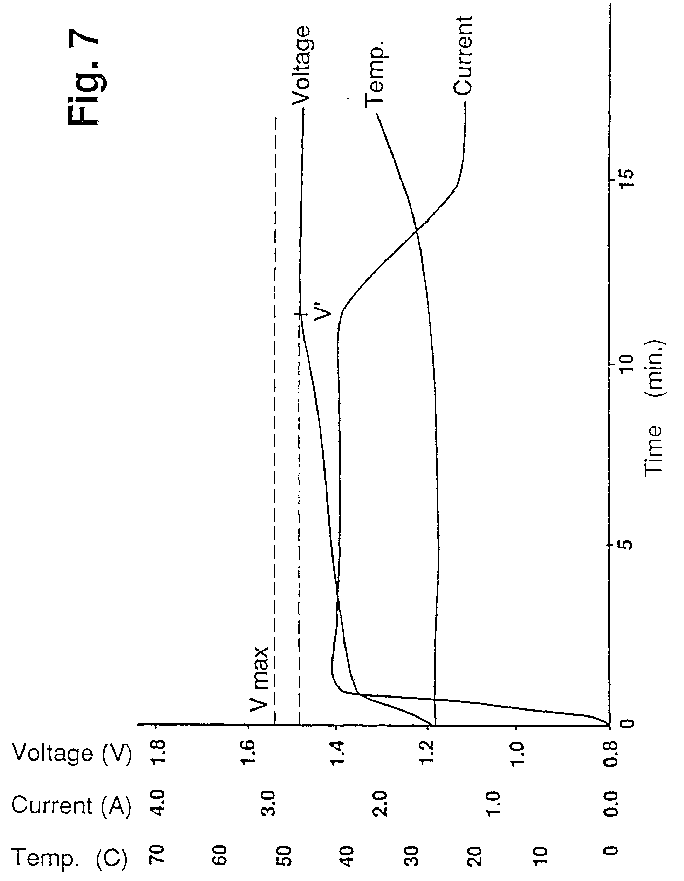

However, some batteries will never reach the predetermined value Vmax determined for this type of battery in question. This fact may be due to various defects or anomalies of the batteries. Fig. 7 shows charging curves for such anomalous battery. During the first period of the charging process the charging curves follow the normal courses as shown in Fig. 3. However, the voltage curve flattens out at a voltage V' which is lower than Vmax. Therefore the stop point of time for the charging process cannot be determined based on the time when the charging voltage reaches Vmax. In such case the maximum charging voltage may be determined in a different manner. As an example the battery voltage may be measured at predetermined time intervals, and the measured values may be compared. If the measured battery voltage has not increased during the last successive measurements and Vmax has not yet been reached, the last measured voltage may be defined as the maximum voltage, V', for this battery and a remaining charging period may be determined starting from the point of time at which V' was first measured.

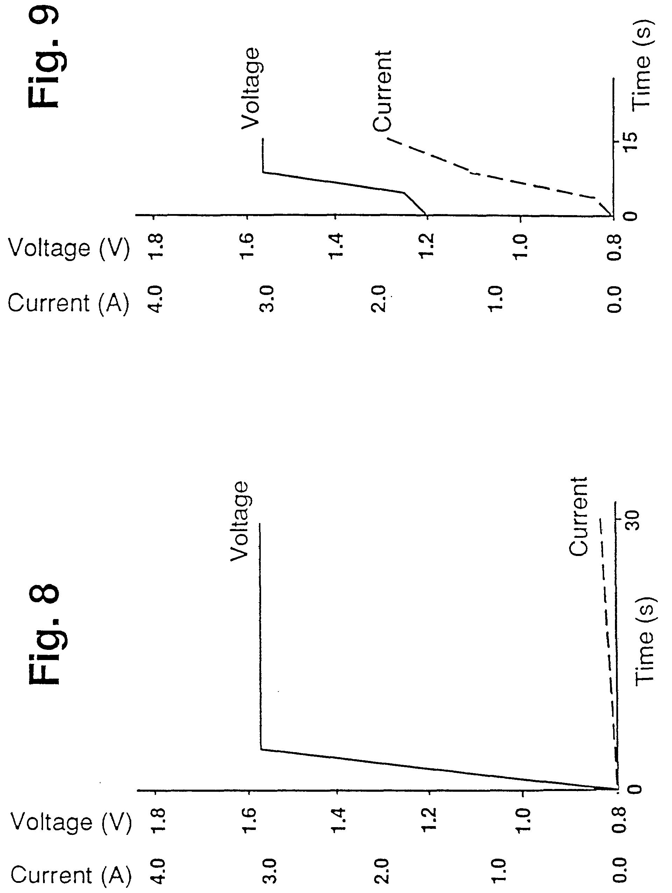

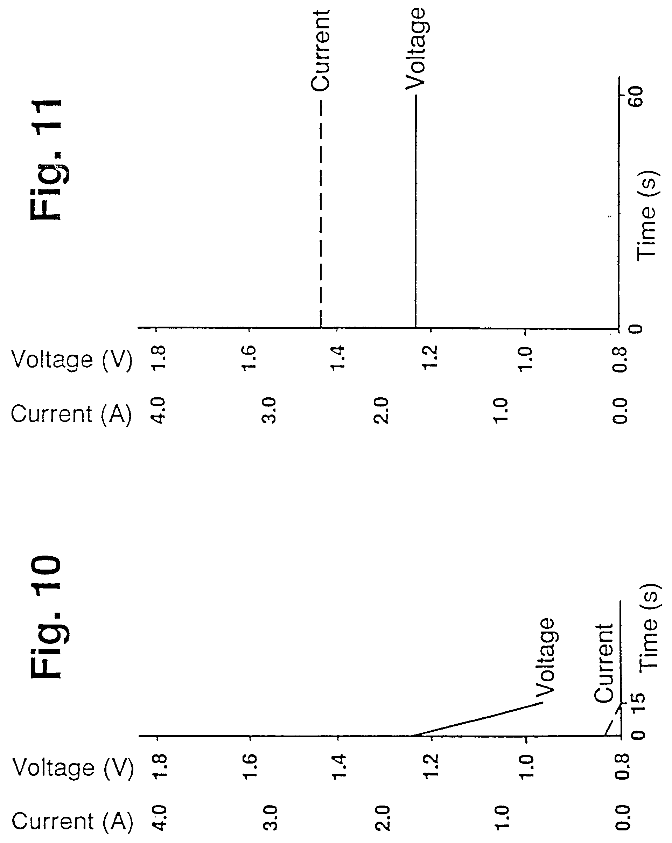

Fig. 8 shows typical first charging curves when test charging a virgin battery, and Fig. 9 shows corresponding charging curves when test charging a fully charged battery. When a battery has to be charged for the first time or for the first time after the battery has been stored for a long time without charging, the chemical reactions which must take place within the battery during the charging process are rather slow to start with. For such batteries, the controlled high current charging process described above cannot be used. For such "virgin batteries" the charging process has to take place with a relatively low, almost constant current supplied to the battery for a relatively long period of time in order to secure that the battery is fully charged. Therefore, before the initiation of the actual charging process, the battery may be exposed to a test charging programme in which the battery is charged for a short period of time in accordance with a normal charging process as described above. However, the starting charging current must be relatively low, for example in the range of 1C/h, and then increased to a higher value which can be in the range of 4C/h, C/h being the so-called C-rate. After a short predetermined period of time, for example a few seconds, or when the voltage across the battery terminals reaches Vmax, the charging process is stopped. The battery is discharged with a relatively high discharging current. Fig. 10 diagrammatically shows discharging curves for the virgin battery charged as illustrated in Fig. 8. Fig. 11 diagrammatically shows discharging curves for the fully loaded battery charged as illustrated in Fig. 9.

Fig. 8 illustrates that a virgin battery will reach the battery voltage Vmax within a very short period of time, for example less than 10 seconds. However, the charging current accepted by the battery is very low. Consequently, as shown in Fig. 10, the virgin battery charged in accordance with Fig. 8 may be fully discharged within a very short period of time, which in the example is less than 1 second. When a test charging to which a battery is subjected results in curves similar to those of Figs. 8 and 10, the control system of the charging apparatus may be instructed to treat the battery as a virgin battery, and during the following charging process a relatively low, almost constant charging current, for example in the order of 0.2 C/h, will be supplied to the battery until the battery is charged to its full capacity.

When testing a fully loaded battery the voltage across the battery terminals reaches Vmax within the same period of time as a virgin battery as shown in Fig. 9. However, contrary to the charging current supplied to the virgin battery, the charging current supplied to the fully loaded battery increases very rapidly. When discharging the fully loaded battery during the testing, a high, nearly constant current flows from the battery within the testing period, and at the same time the battery voltage will be rather constant as is shown in Fig. 11. When the test charging of a battery results in curves similar to those of Figs. 9 and 11 the charging system may be instructed to treat the battery as a fully charged battery which means that the charging process is stopped.

As an alternative, the rates of change of the voltage curves may be measured during the charging and the discharging tests. By comparing the measured rates of change of the voltage curves with reference values the start conditions of the battery can be calculated, and a charging process can be selected for the battery being tested. If necessary, the test programme may involve several subsequent charging and discharging periods in order to obtain the desired information.

When selecting an ideal charging process for a battery it is necessary to have a set of reference parameters for the type of battery to be charged. Thus it is desirable to have a method of determining or selecting a set of reference parameters for a new type of battery.

These parameters may comprise of the battery voltage, the charging and discharging currents, the inner and outer temperatures of the battery, and/or the chemical reactions within the battery cells.

One of the most important parameters is the battery temperature when the battery has just been fully charged, Temp. (100%). When charging further from this point the battery temperature will increase and the battery may be damaged.

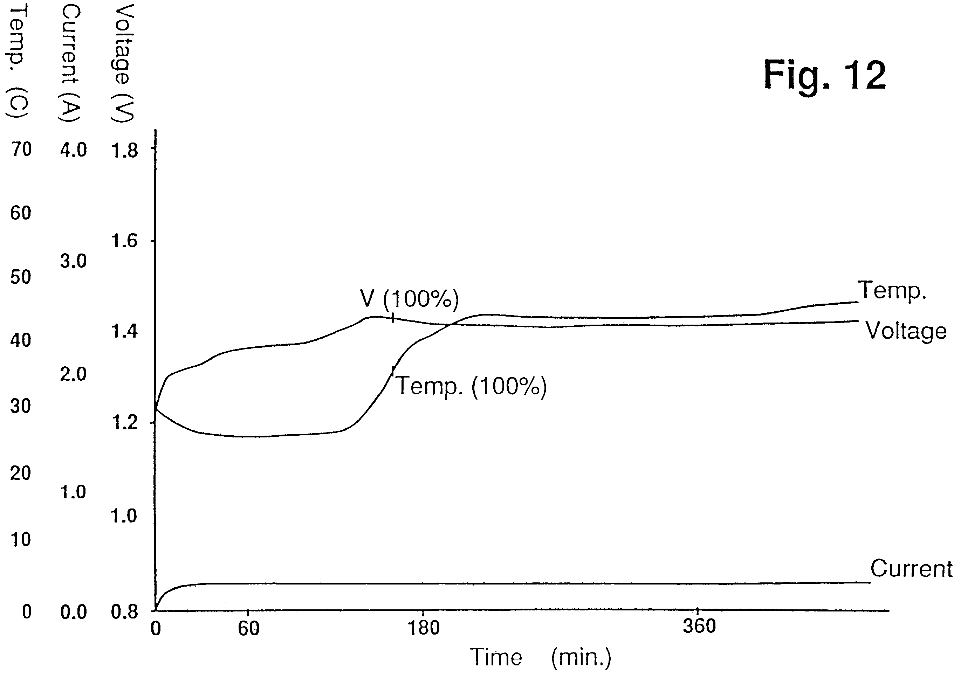

In order to measure Temp. (100%) for a battery of an unknown type without having to much influence from the heat dissipated in the series resistance within the battery, the battery may be charged with a relatively low, almost constant charging current for a relatively long period of time (several hours) in order to secure that the battery is fully charged. When the battery has been charged it may be discharged over a relatively long period of time in order to test whether it was actually fully charged. If not, a new charging process is started with a higher charging current. If yes, a new charging process is started with the same charging current, but this time the charging period of time will be shorter. When this charging process is terminated, the battery is again discharged in order to determine whether the battery has been fully charged. If yes, a new charging process with the same charging current but with an even shorter charging period of time is initiated. If not, a new charging process with the same charging current but with a longer period of charging time is initiated. These charging and discharging processes will continue with the same charging current and with new periods of charging time until the minimum charging time, t(100%), where the battery is just fully charged, has been found. When measuring the temperature of the battery at t(100%), Temp. (100%) can be found for this type of battery and for the given charging current. By measuring the voltage across the battery at t(100%), the value of V(100%) can be found. Fig. 12 shows the course of the voltage and temperature values for a typical charging process in which a relatively low charging current is used. In Fig. 12 the charging current is 2C/h, and the points Temp. (100%) and V(100%) are indicated on the charging voltage and temperature curves shown.

It is to be understood that other methods of determining the value of Temp. (100%) may be used including the measurement of the rate of change of the temperature curve during charging.

Another important parameter is the predetermined maximum voltage Vmax which will vary with the type of battery involved. When using a high speed charging process as illustrated in Fig. 3 the charging process is controlled so that the voltage is maintained at a substantially constant value during the rest of the charging process when Vmax has been reached, the charging process being terminated when a predetermined period of time has lapsed, starting when Vmax is reached.

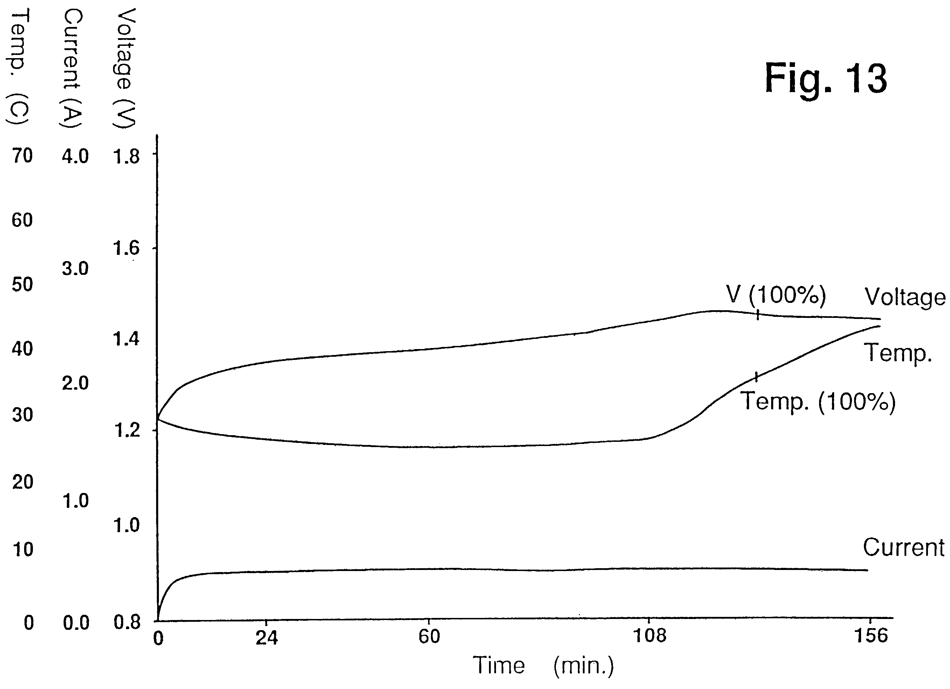

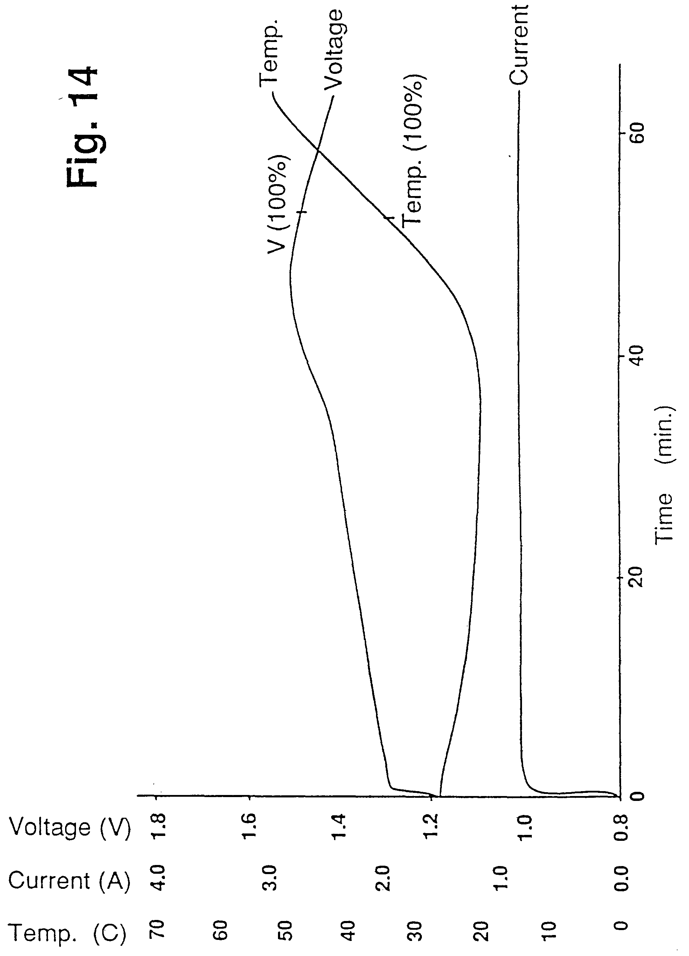

In order to determine Vmax for a new type of battery the battery may be charged with an almost constant charging current which is slightly higher than the charging current used in the above example to determine the temperature Temp. (100%). The rate of change of the voltage curve is measured and compared with the temperature of the battery. If the voltage rate of change is positive at Temp. (100%) a new charging process is initiated with a new, slightly higher charging current than the previous current. This process is repeated until the measured voltage rate of change at Temp. (100%) becomes zero or slightly negative. This procedure is illustrated in Fig. 13 for a charging current of 0,5C/h and in Fig. 14 for a charging current of 1C/h, when using the same battery as in Fig. 12. The measured value of V(100%) for a charging process where the voltage rate of change has just become zero or slightly negative will be a good measure for the value of Vmax for this type of batteries, and the selected value of Vmax should be selected rather close to this measured value of V(100%). Other methods could be used in determining the value Vmax.

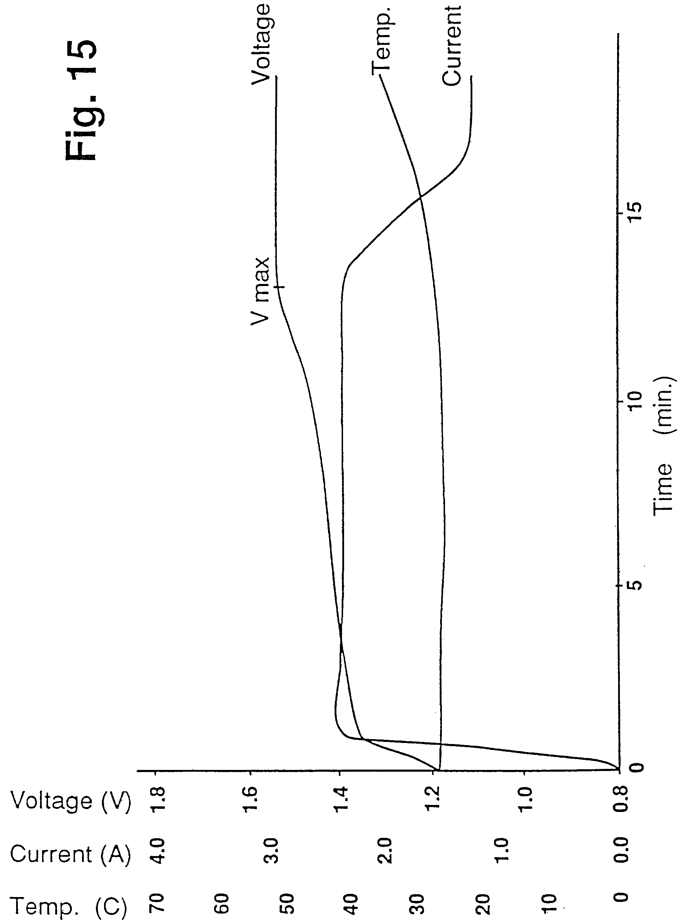

Fig. 15 illustrates a controlled charging process according to the present invention for the same battery as in Figs. 12-14 when using a maximum charging current of 4C/h and a maximum charging voltage Vmax, which has been determined from the measured value of V(100%) in Fig. 13.

By performing the above described measurements of t(100%), Temp. (100%), and V(100%), a set of reference parameters representing reference values of voltage, temperature, current, and charging time may be collected. All of these reference values may be used in determining characteristic charging parameters to be used in a controlled charging process, including alternative ways of calculating Vmax.

The reference parameters to be used in a controlled charging process may be determined for each battery or for each type of batteries by using a first analysing charging process followed by a second analysing charging process. As the battery may comprise several battery cells, the analysing charging processes may also be used in order to determine reference parameters for each cell of the battery.

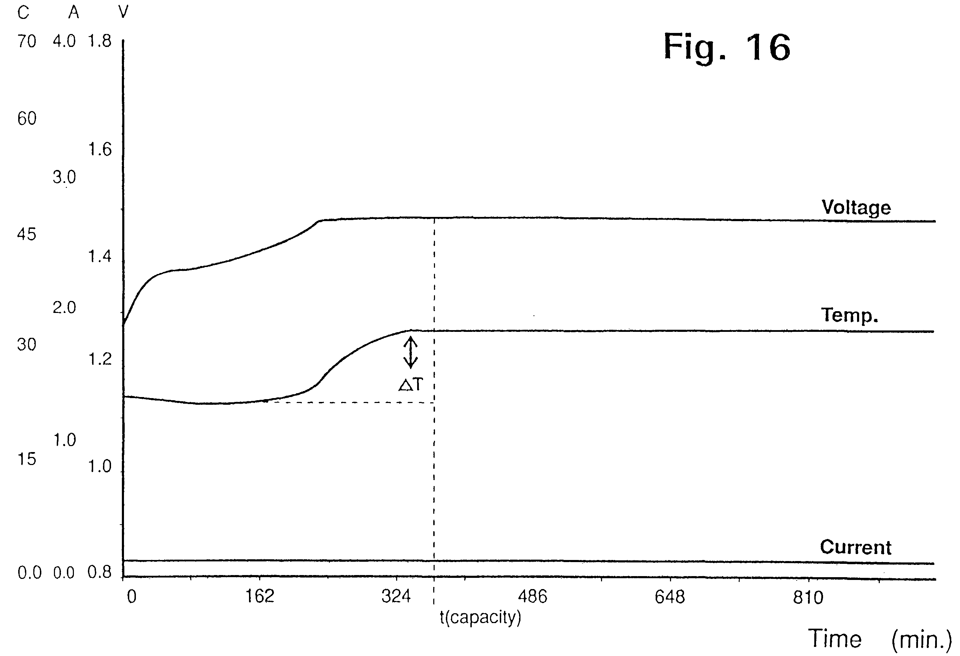

The first analysing charging process is--illustrated in Fig. 16. During this analysing charging process a maximum battery charging temperature difference ΔT is determined by supplying a relatively low, almost constant charging current for a relatively long period of time and surveying the battery temperature and/or the battery terminal voltage. The first analysing charging current should be so low that no substantially increase in the battery voltage is detected for the first six hours of the charging process. However, the charging current should be high enough to ensure a rise in battery voltage after about 10 hours of charging, and the charging current should preferably be around 0.1 C/h, although the exact value of the capacity of the battery may not be known at the time when the first analysing charging process occurs. If the value of the first analysing charge current has been chosen so that the above mentioned requirements of the battery voltage is not fulfilled, a new value of the first analysing charge current should be selected, and the analysing charging process may start all over again. It is preferred that the battery is fully discharged before being subject to any analysing charging process.

If a correct value of the first analysing charging current has been selected, the battery will be fully charged after several hours of charging and no further increase in the battery temperature will be detected. Hence the maximum charging temperature difference ΔT can be determined for the battery by comparing the lowest and the highest values of the measured battery temperature. It is also to be noted that no further increase is detected for the battery voltage when the battery has obtained the fully charged condition. If a temperature sensor is available for each cell of the battery, the maximum charging temperature difference may be determined accordingly for each cell of the battery.

A method has been devises of determining the real value of the capacity of the battery to be charged. This is also done during the first analysing charging process by determining a first charging stop point of time t(capacity)) at the time when no further increase in the battery temperature and/or battery voltage has been detected for a predetermined period of time involving at least two measurements of the battery temperature and/or voltage. Alternatively, t(capacity) may be determined as the point in time where the change in battery temperature and/or battery voltage has decreased below a predetermined level for a predetermined period of time. By calculating the power supplied to the battery during the first analysing charging process until the time t(capacity), which is equal to the time when the battery has been fully charged, the real value of the capacity of the battery may be determined.

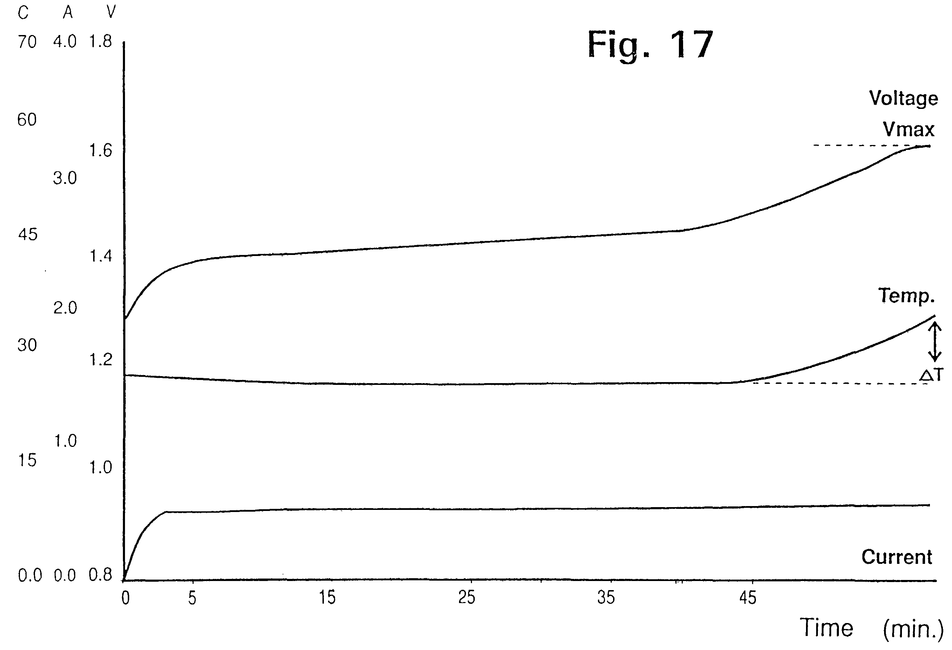

The second charging process is illustrated in Fig. 17. During this analysing charging process a maximum battery terminal voltage is determined by supplying a second, almost constant, analysing charging current to the battery with the second analysing current being equal to the C-rate based on the real capacity value of the battery determined during the first analysing charging process. During the second analysing charging process, the terminal voltage and the battery temperature are being surveyed and the maximum terminal voltage is determined as the voltage measured across the battery terminals at the point in time when the battery temperature has increased by the maximum battery charging temperature difference ΔT which has been determined during the first analysing charging process. If the terminal voltage is surveyed for each cell of the battery then the maximum terminal voltage may be determined in the same way for each cell of the battery, either at the maximum battery charging temperature difference or, if the temperature is surveyed individually for each cell, at the maximum charging temperature difference of the cell.

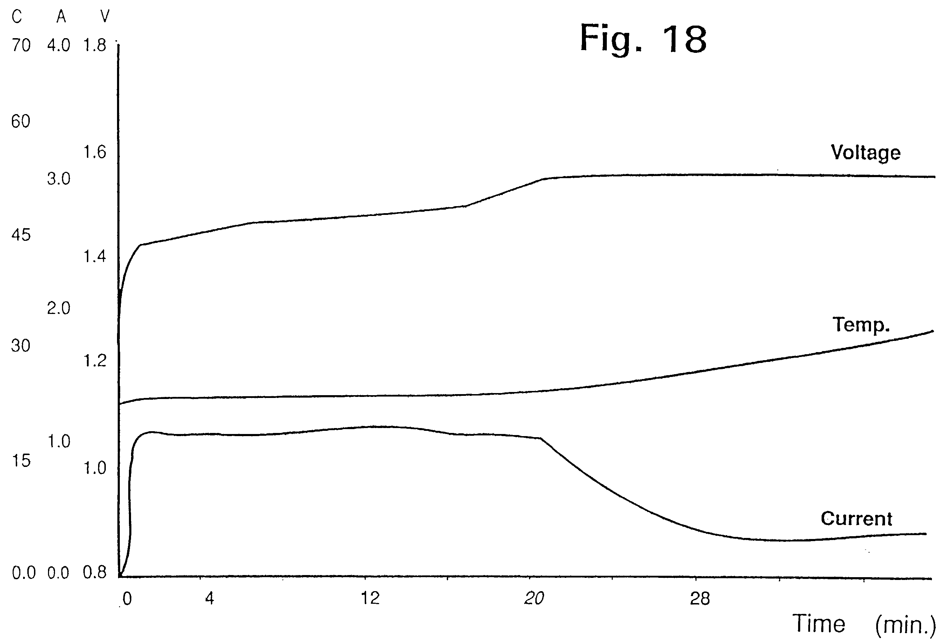

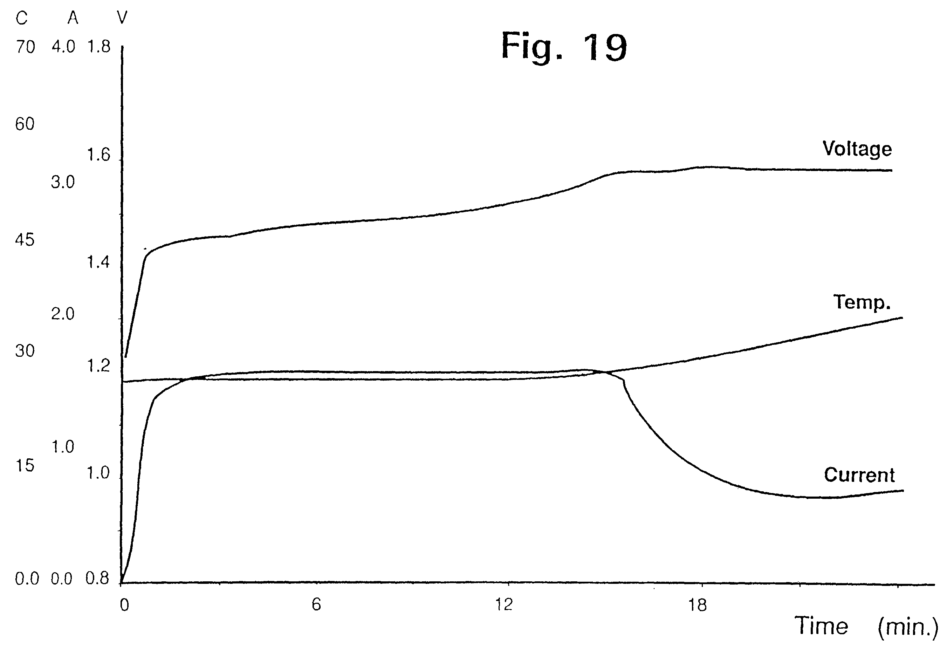

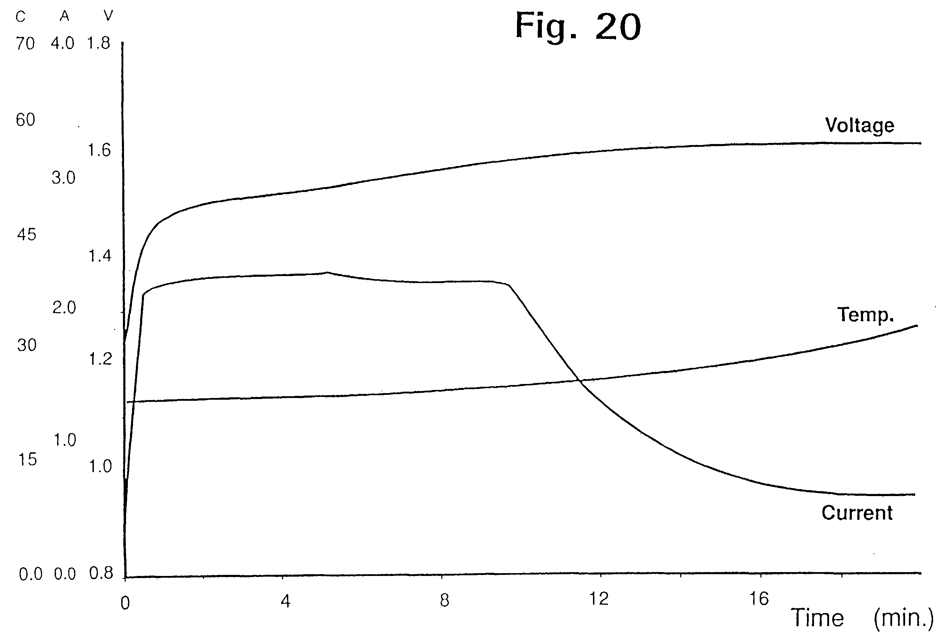

Figs. 18, 19 and 20 shows the charging curves for a NiCd battery when the charging process is controlled in accordance with the results obtained during the first and second analysing charging processes. Thus, the real battery capacity value determined during the first analysing charging process may be used when determining the charging current supplied to the battery during the first part of the charging process. In Figs. 18, 19 and 20 this charging current is equal to 2, 3 and 4 times the C-rate, respectively. During the charging process, the battery terminal voltage is surveyed and when the maximum battery terminal voltage Vmax determined during the second analysing charging process is reached, the charging process is controlled so that the voltage is held constant during the remaining charging process. At the time Tmax when Vmax is reached a remaining charging period may be determined in accordance with the previous discussion and the charging process may be terminated when this remaining charging period has lapsed.

However, the remaining charging period may also be determined in dependency of the value of Tmax, and in a preferred embodiment the remaining charging period is determined by comparing the value of Tmax with stored reference values having corresponding remaining charging periods of time and thus selecting the remaining charging period corresponding to the value of Tmax.

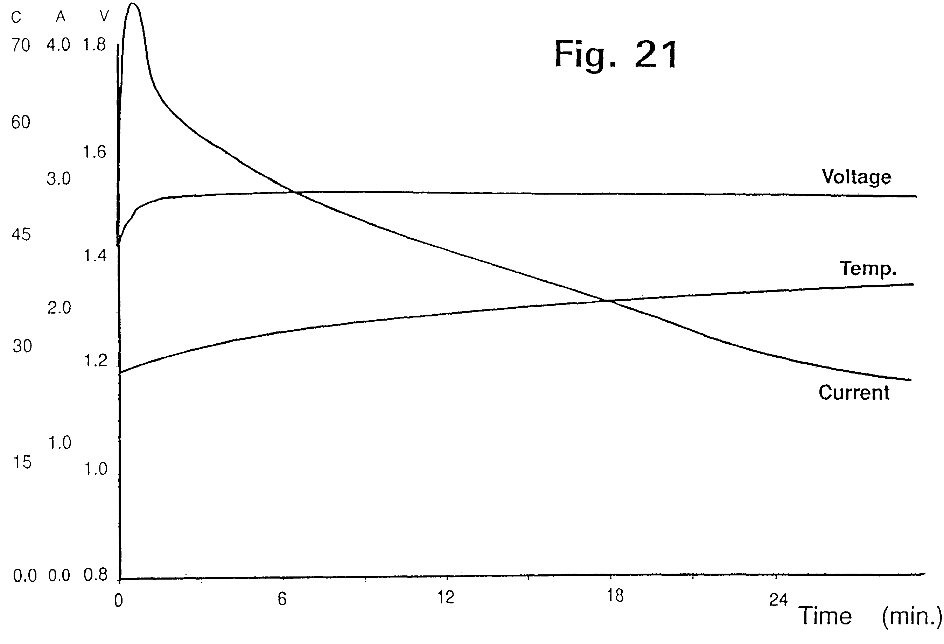

When charging a battery, the battery temperature and/or the charging current may be surveyed, and the charging process may be terminated when the measured rise in temperature equals the maximum battery temperature difference determined during the first analysing charging process. Alternatively, the charging process may be terminated when no further decrease in the charging current has been detected for a predetermined period of time during the remaining charging period. This is illustrated in Fig. 21 which shows the charging curves for a Nickel Metal Hydride battery which is initially charged with a very high charging current. In this case, Vmax is reached very early and the charging process is controlled so that the battery terminal voltage is held constant at Vmax, resulting in a decrease in the charging current, and the charging process is terminated when no further decrease has been detected in the charging current.

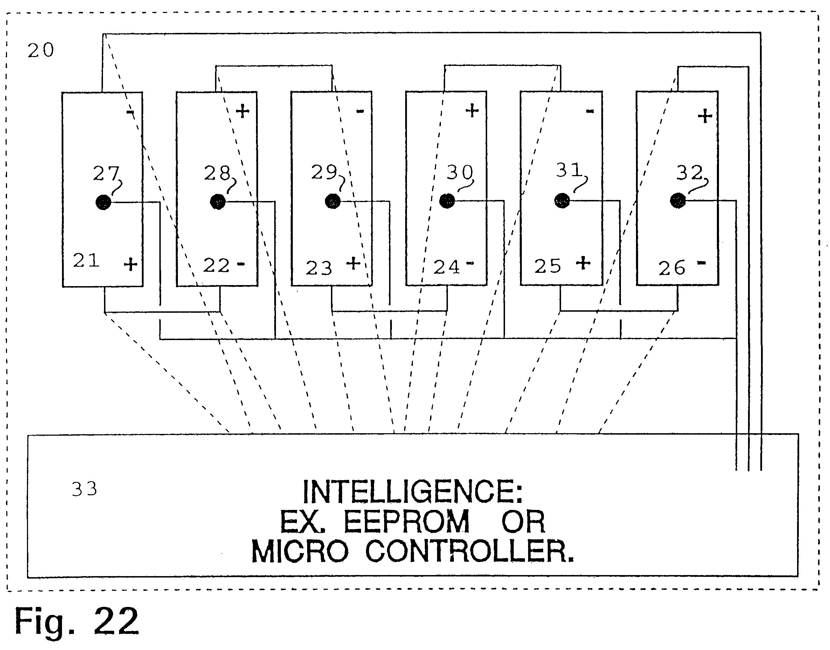

As mentioned above the battery may comprise several battery cells. These cells are connected in series and the resulting battery voltage depends on the number of cells within the battery. However, the characteristics of the battery cells may vary from cell to cell within the battery, and in order to obtain almost full control of the discharging and charging processes of the battery, it may be convenient to be able to measure the voltage and/or temperature of each individual cell during discharge and/or charge of the battery. Thus, it is an aspect of this invention to provide a battery having at least two battery cells and having means for measuring the voltage of each cell. The battery may further comprise information means for storing the measured cell voltages, and in a preferred embodiment of the battery, each cell is also provided with a temperature sensor with the measured temperature being stored in the information means. Fig. 22 shows a block diagram of a battery 20. The battery 20 in Fig. 22 comprises 6 battery cells 21-26 with a temperature sensor 27-32 provided for each cell and information means 33 such as an EEPROM and/or a microprocessor for reading the voltage across each cell and/or the temperature of each cell.

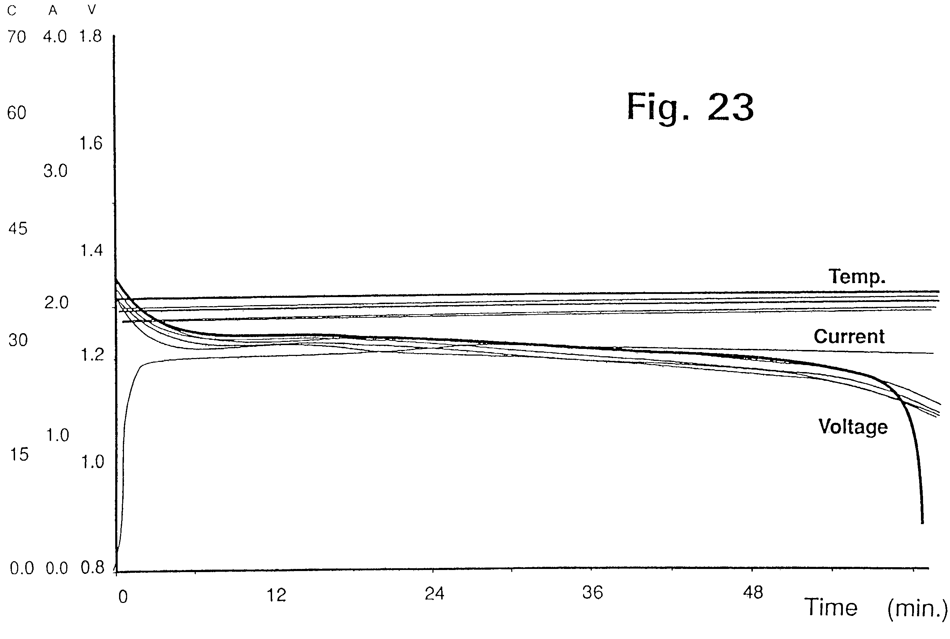

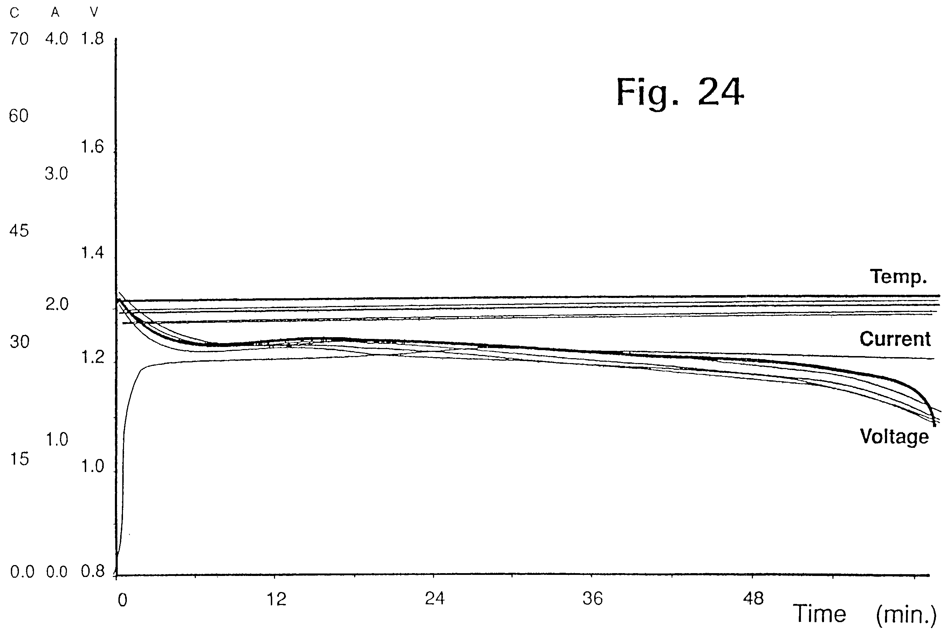

As the characteristic may vary for each cell of the battery it is very important to control the discharging process with respect to the cell showing the largest drop in cell voltage when the battery is being discharged. This is illustrated in Figs. 23 and 24 which shows the discharging curves for each cell in a NiCd battery having 6 cells and being discharged with a constant current. In Fig. 23 the overall voltage of the battery is used in order to stop discharging of the battery allowing at least one of the cells to obtain a relatively large voltage drop and thus being discharged to a very high degree. As a result, this cell may not be fully charged when the battery is subsequently being re-charged and the capacity of the battery may decrease. This may be avoided by the discharging process shown in Fig. 24, where the discharging process is controlled so that the discharge of the battery is terminated when the first of the cell voltage curves drops to a predetermined level. This level might be in the range of 0.8-1 Volt.

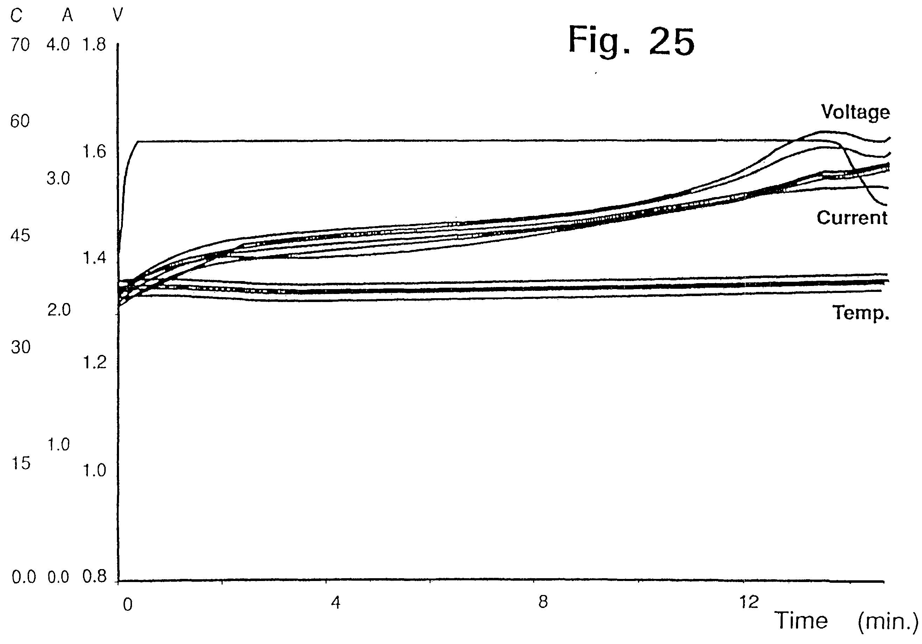

Similarly, the maximum cell voltage will not be reached at the same time during a charging process. This is illustrated in Fig. 25 which shows the cell voltage curves for each cell during charging of a NiCd battery. Here it may be observed that one of the cells reaches the maximum cell voltage before the other cells and the remaining charging period of the charging process should be determined at the point in time when one of the cell voltages first reaches the maximum cell voltage.

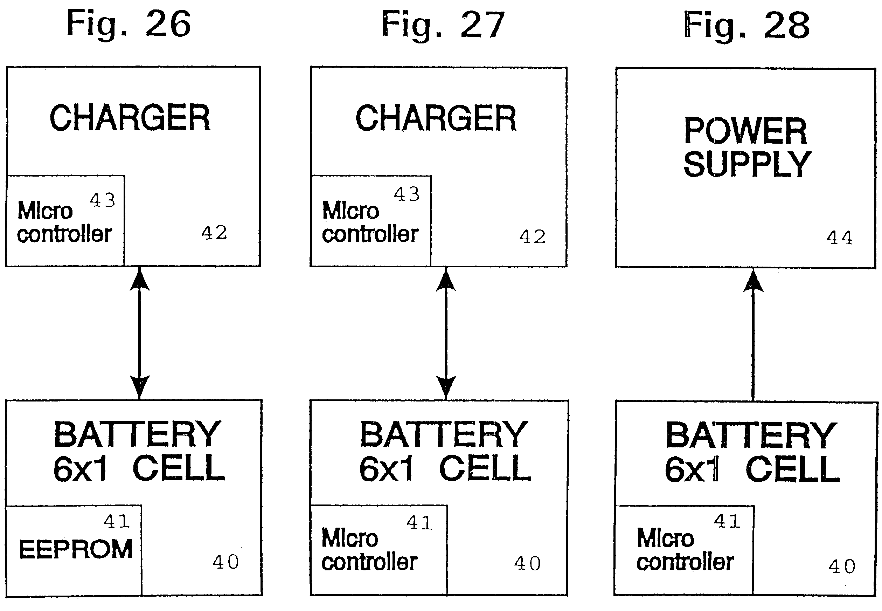

In Figs. 26, 27 and 28 the block diagrams of different embodiments of a battery system according to the present invention are shown. Fig. 26 shows a system wherein the battery 40 comprises information means 41 such as an EEPROM and the charging apparatus 42 comprises the controlling device 43 such as a microprocessor. However, the information means 41 of the battery 40 may also comprise a controlling device such as a microprocessor as shown in Fig. 27. Fig. 28 shows an embodiment wherein a charging controlling device is included within the information means 41 of the battery 40 and in this case, the battery 40 only needs to be connected to a power supply 44 which is controlled by the information means 41 of the battery.

It should be understood that the above described first and/or second analysing charging processes may be used in connection with a battery wherein measured data and parameters may be determined and/or stored within the information means of the battery. Alternatively, data may be collected by a computer system which will supply the characteristic parameters to the charging apparatus having a memory for storing these parameters.

It should also be understood that the above described methods of the present invention are not valid only for a single type of batteries such as Nickel Cadmium batteries but should also be applicable for other types of re-chargeable batteries such as for example Lithium batteries and Nickel Metal Hydride batteries.

## Claims

1. A battery charging system, comprising:
a rechargeable battery (40) including at least one rechargeable battery cell, a pair of battery terminals and information means (41) for containing information about the battery in the form of an information code,
a charging apparatus (42) for charging the rechargeable battery (40), the charging apparatus (42) including a pair of charger terminals, means for releasably interconnecting the battery and the charging apparatus so that the battery terminals are in electrical conductive contact with the charger terminals, and information receiving means for electronically reading or sensing the information code of the information means of the battery,
said charging apparatus (42) further comprising control means (43) for controlling the charging process based on the information code read or sensed by the information receiving means of the charger,
**characterized in that**
said battery information code comprises information about at least one of the type, the capacity, the maximum temperature, or any other battery specification and/or about at least one of the charging status, the condition, the last charging process, the last discharging process, time period lapsed since the last charging process, the time period lapsed since the last discharging process, charging parameter algorithms, the internal pressure of the battery or any other characteristic.

2. A battery charging system according to claim 1, wherein the battery information code further comprises information about the maximum charging voltage and/or the maximum charging current of the battery.

3. A battery charging system according to any of the preceding claims, wherein the information means (41) comprises an electronic memory for storing the battery information.

4. A battery charging system according to any of the preceding claims, wherein the information means (41) comprises an EEPROM.

5. A battery charging system according to any of the preceding claims, wherein the controlling means (43) of the charging apparatus (42) comprises a micro processor.

6. A battery charging system according to any of the preceding claims, wherein the rechargeable battery (40) is a Nickel Cadmium battery, a Nickel Metal Hydride battery or a Lithium battery.

7. A rechargeable battery comprising at least one rechargeable battery cell, a pair of battery terminals and information means (41) comprising battery information in the form of an information code,
said information code having a form which may be electronically read or sensed by information receiving means of a corresponding battery charging apparatus (42),
**characterized in that**
said battery information code comprises information about at least one of the type, the capacity, the maximum temperature, or any other battery specification and/or about at least one of the charging status, the condition, the last charging process, the last discharging process, time period lapsed since the last charging process, the time period lapsed since the last discharging process, charging parameter algorithms, the internal pressure of the battery or any other characteristic.

8. A rechargeable battery according to claim 7, wherein the battery information code further comprises information about the maximum charging voltage and/or the maximum charging current of the battery.

9. A rechargeable battery according to any of claims 7 and 8, wherein the information means comprises an electronic memory for storing the battery information.

10. A rechargeable battery according to any of claims 8 to 9, wherein the information means comprises an EEPROM.

11. A rechargeable battery according to any of claims 8 to 10, wherein the rechargeable battery (40) is a Nickel Cadmium battery, a Nickel Metal Hydride battery or a Lithium battery.
